# EUROPEAN PATENT SPECIFICATION

(11) **EP 2 484 799 B1**
(45) Date of publication and mention of the grant of the patent: **31.10.2018**
(21) Application number: 12153680.9
(22) Date of filing: 02.02.2012
(51) Int. Cl.: H01J 37/34, C23C 14/32

(54) **Segmented post cathode**
Segmentierte Rohrkathode
Cathode tubulaire segmentée

(30) Priority: 02.02.2011 US 201113019325
(43) Date of publication of application: 08.08.2012
(73) Proprietor: United Technologies Corporation, Farmington, CT 06032 (US)
(72) Inventor: Tryon, Brian S., Glastonbury, CT 06033 (US); Beers, Russell A., Manchester, CT 06040 (US)
(74) Representative: Dehns

(56) References cited:
- EP-A1- 1 997 932
- US-A1- 2004 074 770
- US-A1- 2008 138 529

## Description

### BACKGROUND

The present disclosure is directed toward a physical vapor deposition (PVD) system, and particularly to a segmented post cathode for use therein.

Cathodic arc is one type of physical vapor deposition (PVD) system which vaporizes a material and deposits that material on a piece, thereby coating the piece with a thin layer of the material. PVD systems use a cathode/anode arrangement where the cathode includes an evaporation surface made from the coating material. The cathode and the anode of the PVD system are contained within a vacuum chamber. A power source is connected to the cathode and the anode with the positive connection of the power source connected to the anode and the negative connection of the power source connected to the cathode. By connecting the positive power connection to the anode and the negative power connection to the cathode, a charge disparity between the anode and the cathode is generated. The charge disparity causes an electrical arc to jump between the cathode and the anode. In standard cathodic arc systems, the arc location is random over the surface of the cathode. The arcing causes the surface of the cathode to vaporize at the point where the arc occurred. The plasma formed from the vaporized cathode material then coats the electrically biased piece(s) contained in the vacuum chamber.

In order to control the density and distribution of the coating, steered arc systems control the location of the arc on the cathode's surface by manipulating magnetic fields. The magnetic field is created using an array of magnets or electromagnets which force the arc into the desired location(s) on the source (cathode) material and further helps to keep the arc away from undesirable/shielded locations of the apparatus.

Additionally, multiple coatings of different materials can be required. Typically, in order to implement multiple-layer coatings, a first layer is applied using the method described above. After the first layer is applied, the part is removed from the PVD system, the cathode is replaced with a cathode constructed of the second coating material, and the process is repeated. Further layers beyond the second require additional cathode changes. Systems with multiple sources can produce added complexities, such as a plurality of triggering mechanisms, a plurality of cathode shielding, and a plurality of cooling systems.

US 2008/0138529 discloses a segmented post cathode according to the preamble of claim 1.

EP 1997932 discloses a method of arc ion plating and a target for use therein wherein the target is dividable into longitudinal end portions and a central portion.

US 2004/0074770 A1 discloses a cathode for a deposition process comprising segments having inter engaging tapered cuts.

### SUMMARY

In accordance with the present invention, there is provided a segmented post cathode as set forth in claim 1.

### BRIEF DESCRIPTION OF THE DRAWINGS

The disclosure can be further understood by reference to the following detailed description when considered in connection with the accompanying drawings wherein:
Figure 1 illustrates an example steered arc post cathode system having multiple post cathode segments.
Figure 2 illustrates a first example post segment, falling within the scope of the invention.
Figure 3 illustrates a second example post segment, not falling within the scope of the invention.
Figure 4 illustrates a third example post segment, falling within the scope of the invention.

### DETAILED DESCRIPTION

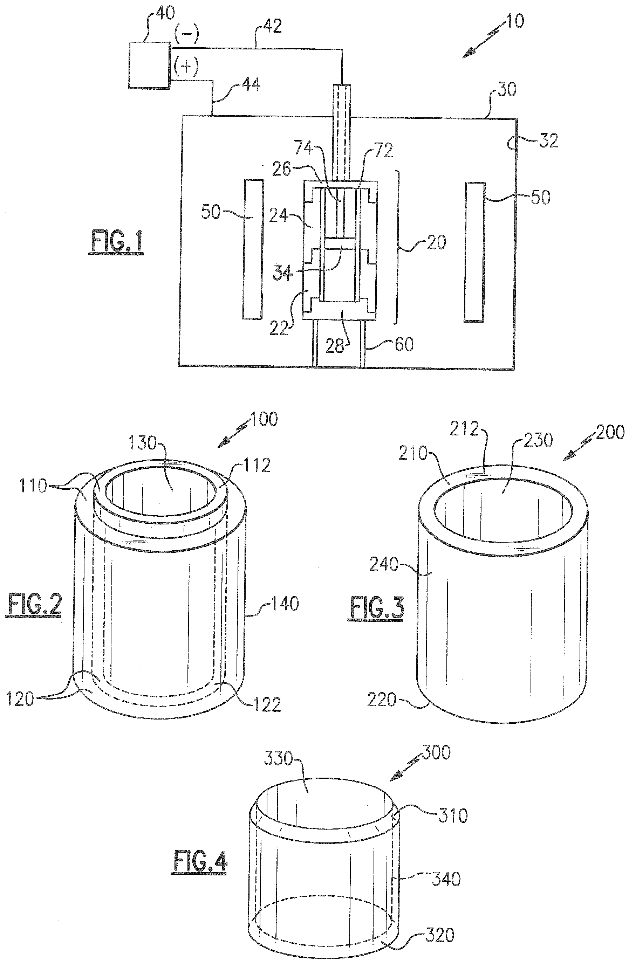

Figure 1 illustrates an example steered arc physical vapor deposition (PVD) system 10. The PVD system 10 includes a vacuum chamber 30 surrounding a cylindrical post cathode 20. The vacuum chamber 30 includes an inner surface 32 that further doubles as an anode. Alternately, an independent anode (not shown) can be connected within the vacuum chamber 30 to the same effect. Each of the anode 32 and the cylindrical post cathode 20 are connected to a power source 40. The power source 40 provides a negative charge 42 to the cylindrical cathode 20 and a positive charge 44 to the anode 32 during operation, thereby enabling cathodic arcing. A part 50 is located within the vacuum chamber 30 and receives a coating during operation of the PVD system 10.

The cylindrical cathode 20 is constructed of two cathode segments 22, 24, a top cathode cap 26 and a bottom cathode cap 28. The cathode segments 22, 24 may be held in place via a thin tube 72 that is press-fit inside the cylindrical cathode 20. The top cathode cap 26 nests with a top nesting section 110 (described below with regards to Figure 2) of the cathode segments 24 and the bottom cathode cap 28 nests with a bottom nesting section 120 (described below with regards to Figure 2) of the bottom cathode segment 22. A magnet 34 is suspended within the cathode 20 and can be actuated between cathode segments 22, 24 using a vertically translatable shaft 74. The position of the magnet 34 controls the position of the cathodic arc according to known principles. The cylindrical cathode 20 is located in the center of the PVD system 10 via a plurality of cathode supports 60 and the actuation shaft 74.

Although the example PVD system 10, illustrated in Figure 1, uses two cathode segments 22, 24, multiple additional segments can be used. Furthermore, the segmented post cathode 20 allows for cathode segments 22, 24 of varied axial lengths to be used.

A more detailed view of an example cathode segment 100 is illustrated in Figure 2. The cathode segment 100 has a top nesting section 110, a bottom nesting section 120, and a side wall 140. In the illustrated example, the entire cathode segment 100 is constructed of the coating material and provides an evaporation source material surface for the cathode. The cathode segment 100 further includes an axial void 130 in which the thin tube 72 (illustrated in Figure 1) can be inserted. The axial void 130 further provides for the magnet 34 to be moved between segments 100 during operation of the PVD system, and thereby allows the cathodic arc to be steered between the segments 100.

The top nesting section 110 of the cathode segment 100 is a radially inner ring portion 112 extending axially away from a body of the cathode post segment 100. The bottom nesting section 120 is an inner ring intrusion 122, extending axially inward toward the body of the cathode post segment 100. The inner ring extension portion 112 extends out to a same axial length as the intruding inner ring portion 122. The intruding inner ring inclusion portion 122 of the bottom nesting section 120 receives an inner ring extension section 112 of an adjacent post cathode segment 100, thereby "nesting" the two cylindrical post cathodes. The nesting function allows multiple post cathode segments (100) to be stacked together to form a single post cathode. When two segments 100 are stacked together, the arrangement appears as illustrated in Figure 1. The top cathode cap 26 (illustrated in Figure 1) and the bottom cathode cap 28 (illustrated in Figure 1) each include corresponding nesting features, which provide for the caps 26, 28 to close the post cathode 20.

An cathode segment 200 not falling within the scope of the invention is illustrated in Figure 3. As with the previous example, the cathode segment 200 includes a top nesting section 210, a bottom nesting section 220 and a solid side wall 240. Also included in the cathode segment 200 is an axial void 230 in which a thin tube can be press-fit, and through which a magnet may be actuated. In the example segment 200 of Figure 3, the top and bottom nesting sections 210, 220 are a single planar cut and provide a contact surface 212 for abutting an adjacent cathode segment 200.

Since the cathode segments 200 use a simple planar cut for the nesting sections 210, 220, the top nesting section 210 and the bottom nesting section 220 are interchangeable. The interchangeability allows the cathode segment 200 to be reversible, with the top nesting section 210 of one cathode segment abutting an adjacent cathode segment 200 top nesting section 210.

A third alternative cathode segment 300 is illustrated in Figure 4. The third cathode segment 300 includes a top nesting section 310, a bottom nesting section 320, a center void 330, and a side wall 340. The third cathode segment 300 differs from the first segment 100 and second segment 200 in that it uses a conical protrusion 310 and inclusion 320 as the nesting feature. In all other respects the three cathode segments 100, 200, 300 are the same.

In each of the cathode segments 100, 200, 300 of Figures 2, 3 and 4, a cylindrical post cathode segment 100, 200, 300 is illustrated. Alternate shapes, such as a rectangular post, could be used and still fall within the above disclosure. By using two or more post segments 22, 24, as is illustrated in Figure 1, in a steered arc PVD system, a bi-layer coating (a coating having at least a first layer of a first coating and a second layer of a second coating) can be deposited on the part 50 in a single process. This functionality is achieved using at least one cathode segment constructed of the first coating material and another cathode segment constructed of the second coating material. Using a steered arc PVD system, such as the PVD system 10 illustrated in Figure 1, the location of the cathodic arc can be controlled using the magnet 34. Control of the cathodic arc location controls which material is vaporized as a result of the arcing. By way of example, the arc may be controlled by maintaining the magnet 34 within a first cathode segment 22 for a first period of time and within a second cathode segment for a second period of time. Thus, material from the first segment 22 is deposited on the part 50 during a first period, and the material from the second segment 24 is deposited during a second period.

In a standard PVD system with random arcing, the cathodic arc can either favor or disfavor certain areas of the cathode due to variances in the cathode material. This favoring or disfavoring is exacerbated when multiple different materials are used to the point that one of the materials can have over 90% of the arcing. A steered arc system allows the arc position to be controlled, and thereby prevents the PVD arcing from improperly favoring one material over another.

In PVD systems using a traditional puck style cathode, it is possible for the random arcing to favor a certain point of the cathode. The favoring can result in wearing out the cathode at a select location, rather than evenly over the surface of the cathode. As such, traditional solid puck style cathode segments typically only get 20-40% material usage before they are no longer suitable as a cathode. By modifying the cathode to a hollow post cathode, such as the segmented cylindrical post cathode 20 illustrated in Figure 1, and controlling the arc location, arc favoring is dramatically reduced, thereby providing for at least approximately 60-70% of the material to be used.

Although an example has been disclosed, a worker of ordinary skill in this art would recognize that certain modifications would come within the scope of the claims. For that reason, the following claims should be studied to determine their true scope and content.

## Claims

1. A segmented post cathode comprising:
a plurality of post segments (22,24), each of said segments (22,24) having an aligned central axis;
each of said segments (22,24) abutting at least one adjacent segment;
wherein each of said post segments (22,24) comprises a cylinder (100;200;300) of evaporation source material, said cylinder having a center axis in an axial void (130;230;330);
**characterised in that**:
the cathode comprises a top cathode cap (26) and a bottom cathode cap (28);
said top cathode cap (26) having a nesting formation for nesting with a top post segment (24) and said bottom cathode cap (28) having a nesting formation for nesting with a bottom post segment (22); and **in that**
each segment (22, 24) comprises a top nesting section (110;210;310) for connecting to and nesting with another segment (22,24) or the top cathode cap (26); and a bottom nesting section (120;220;320) for connecting to and nesting with another segment (22,24) or the bottom cathode cap (28), wherein one of said top nesting section (110;210;310) and said bottom nesting section (120;220;320) protrudes into an adjacent segment (22, 24) or cathode cap (26, 28), and wherein the other of said top nesting section (110;210;310) and said bottom nesting section (120;220;320) receives a protrusion from an adjacent segment (22, 24) or cathode cap (26, 28).

2. The segmented post cathode of claim 1, wherein said plurality of post segments (22,24) comprises at least one post segment (22,24) comprising a first coating material and at least one post segment (22,24) comprising a second coating material,

3. The segmented post cathode of claim 2, wherein said segmented post cathode comprises at least a first segment (22) constructed of a first material, and a second segment (24) constructed of a second material.

4. The segmented post cathode of any preceding claim, wherein said nesting sections comprises a conical protrusion (310) protruding axially away from said cylinder, or a conical intrusion (320) protruding axially inward toward a center of said segment.

5. The segmented post cathode of any of claims 1 to 3, wherein said nesting sections comprises a radially inner ring (112) protruding axially away from a post segment body or a radially inner ring (122) intruding axially into said post segment body.

6. The segmented post cathode of any preceding claim, wherein each of said segments (22,24) has a material use capacity of at least 50%, for example a material use capacity of approximately 60-70%.

7. The segmented post cathode of any preceding claim, wherein said segmented post cathode comprises an internal magnet (34) capable of moving axially between at least a first segment (22) and a second segment (24).

8. A physical vapor deposition (PVD) system (10) comprising:
a cathode (20) as set forth in any preceding claim, and a magnet (34) suspended in a shared void within said cathode segments (22,24);
said magnet (34) being connected to a shaft (74) such that said magnet (34) can be actuated axially between said segments (22,24).

9. The PVD system of claim 8, further comprising a vacuum chamber (30) having an inner surface (32), and wherein said cathode (20) is within said vacuum chamber (30).

10. The segmented post cathode or PVD system of any preceding claim, further comprising a thin tube (72) (in said void) wherein said thin tube (72) holds each of said segments (22,24) in place.

## Patentansprüche

1. Segmentierte Rohrkathode, umfassend:
eine Vielzahl von Rohrsegmenten (22,24), wobei jedes der Segmente (22, 24) eine ausgerichtete Mittelachse aufweist;
wobei jedes von den Segmenten (22, 24) an zumindest einem benachbarten Segment angrenzt;
wobei jedes von den Rohrsegmenten (22, 24) einen Zylinder (100; 200; 300) eines Verdampfungsausgangsmaterials umfasst, wobei der Zylinder eine Mittelachse in einem axialen Hohlraum (130; 230; 330) aufweist;
**dadurch gekennzeichnet, dass**:
die Kathode eine obere Kathodenkappe (26) und eine untere Kathodenkappe (28) umfasst;
wobei die obere Kathodenkappe (26) eine Verschachtelungsausbildung zum Verschachteln in einem oberen Rohrsegment (24) aufweist und die untere Kathodenkappe (28) eine Verschachtelungsausbildung zum Verschachteln in einem unteren Rohrsegment (22) aufweist; und dadurch, dass jedes Segment (22, 24) einen oberen Verschachtelungsabschnitt (110; 210; 310) zum Verbinden mit und Verschachteln in einem anderen Segment (22, 24) oder der oberen Kathodenkappe (26);
und einen unteren Verschachtelungsabschnitt (120; 220; 320) zum Verbinden mit und Verschachteln in einem anderen Segment (22, 24) oder der unteren Kathodenkappe (28) umfasst, wobei eines von dem oberen Verschachtelungsabschnitt (110; 210; 310) und dem unteren Verschachtelungsabschnitt (120; 220; 320) in ein benachbartes Segment (22, 24) oder eine benachbarte Kathodenkappe (26, 28) hineinragt und wobei der andere von dem oberen Verschachtelungsabschnitt (110; 210; 310) und dem unteren Verschachtelungsabschnitt (120; 220; 320) einen Vorsprung von einem benachbarten Segment (22, 24) oder einer benachbarten Kathodenkappe (26, 28) aufnimmt.

2. Segmentierte Rohrkathode nach Anspruch 1, wobei die Vielzahl von Rohrsegmenten (22, 24) zumindest ein Rohrsegment (22, 24), das ein erstes Beschichtungsmaterial umfasst, und zumindest ein Rohrsegment (22, 24) umfasst, das ein zweites Beschichtungsmaterial umfasst.

3. Segmentierte Rohrkathode nach Anspruch 2, wobei die segmentierte Rohrkathode zumindest ein erstes Segment (22), das aus einem ersten Material konstruiert ist, und ein zweites Segment (24) umfasst, das aus einem zweiten Material konstruiert ist.

4. Segmentierte Rohrkathode nach einem der vorangehenden Ansprüche, wobei die Verschachtelungsabschnitte einen kegelförmigen Vorsprung (310), der axial von dem Zylinder weg herausragt, oder einen kegelförmigen Vorsprung (320) umfasst, der axial in Richtung einer Mitte des Segments hineinragt.

5. Segmentierte Rohrkathode nach einem der Ansprüche 1 bis 3, wobei die Verschachtelungsabschnitte einen radialen Innenring (112), der axial von einem Rohrsegmentkörper weg herausragt, und einen radialen Innenring (122) umfasst, der axial in den Rohrsegmentkörper hineinragt.

6. Segmentierte Rohrkathode nach einem der vorangehenden Ansprüche, wobei jedes der Segmente (22, 24) eine Materialverbrauchskapazität von mindestens 50 % aufweist, zum Beispiele eine Materialverwendungskapazität von etwa 60-70 %.

7. Segmentierte Rohrkathode nach einem der vorangehenden Ansprüche, wobei die segmentierte Rohrkathode einen internen Magneten (34) umfasst, der sich axial zwischen zumindest einem ersten Segment (22) und einem zweiten Segment (24) bewegen kann.

8. System (10) zur physischen Dampfabscheidung (physical vapor deposition - PVD), umfassend:
eine Kathode (20) gemäß einem der vorangehenden Ansprüche, und einen Magneten(34), der in einem geteilten Hohlraum innerhalb der Kathodensegmente (22, 24) aufgehängt ist;
wobei der Magnet (34) derart mit einer Welle (74) verbunden ist, dass der Magnet (34) axial zwischen den Segmenten (22, 24) bewegt werden kann.

9. PVD-System nach Anspruch 8, ferner umfassend eine Vakuumkammer (30), die eine Innenfläche (32) aufweist, und wobei sich die Kathode (20) innerhalb der Vakuumkammer (30) befindet.

10. Segmentierte Rohrkathode oder PVD-System nach einem der vorangehenden Ansprüche, ferner umfassend ein dünnes Rohr (72) (in dem Hohlraum), wobei das dünne Rohr (72) jedes von den Segmenten (22, 24) in Position hält.

## Revendications

1. Cathode tubulaire segmentée comprenant :
une pluralité de segments tubulaires (22, 24), chacun desdits segments (22, 24) ayant un axe central aligné ;
chacun desdits segments (22, 24) jouxtant au moins un segment adjacent ;
dans laquelle chacun desdits segments tubulaires (22, 24) comprend un cylindre (100; 200; 300) de matériau source d'évaporation, ledit cylindre ayant un axe central dans un vide axial (130 ; 230 ; 330) ;
**caractérisée en ce que** :
la cathode comprend un couvercle de cathode supérieur (26) et un couvercle de cathode inférieur (28) ;
ledit couvercle de cathode supérieur (26) ayant une formation d'emboîtement afin de s'emboîter avec un segment tubulaire supérieur (24) et ledit couvercle de cathode inférieur (28) ayant une formation d'emboîtement afin de s'emboîter avec un segment tubulaire inférieur (22) ; et **en ce que** chaque segment (22, 24) comprend une section d'emboîtement supérieure (110; 210; 310) afin se raccorder à et de s'emboîter avec un autre segment (22, 24) ou le couvercle de cathode supérieur (26); et une section d'emboîtement inférieure (120; 220; 320) afin se raccorder à et de s'emboîter avec un autre segment (22, 24) ou le couvercle de cathode inférieur (28), dans laquelle l'une de ladite section d'emboîtement supérieure (110 ; 210 ; 310) et ladite section d'emboîtement inférieure (120 ; 220 ; 320) fait saillie dans un segment adjacent (22, 24) ou le couvercle de cathode (26, 28), et dans laquelle l'autre de ladite section d'emboîtement supérieure (110 ; 210 ; 310) et ladite section d'emboîtement inférieure (120 ; 220 ; 320) reçoit une saillie d'un segment adjacent (22, 24) ou du couvercle de cathode (26, 28).

2. Cathode tubulaire segmentée selon la revendication 1, dans laquelle ladite pluralité de segments tubulaires (22, 24) comprend au moins un segment tubulaire (22, 24) comprenant un premier matériau de revêtement et au moins un segment tubulaire (22, 24) comprenant un second matériau de revêtement.

3. Cathode tubulaire segmentée selon la revendication 2, dans laquelle ladite cathode tubulaire segmentée comprend au moins un premier segment (22) composé d'un premier matériau, et un segment tubulaire (24) composé d'un second matériau.

4. Cathode tubulaire segmentée selon une quelconque revendication précédente, dans laquelle lesdites sections d'emboîtement comprennent une saillie conique (310) faisant saillie axialement à distance dudit cylindre, ou une intrusion conique (320) faisant saillie axialement vers l'intérieur vers un centre dudit segment.

5. Cathode tubulaire segmentée selon l'une quelconque des revendications 1 à 3, dans laquelle lesdites sections d'emboîtement comprennent une bague radialement intérieure (112) faisant saillie axialement à distance d'un corps de segment tubulaire ou une bague radialement intérieure (122) pénétrant axialement dans ledit corps de segment tubulaire.

6. Cathode tubulaire segmentée selon une quelconque revendication précédente, dans laquelle chacun desdits segments (22, 24) a une capacité d'utilisation de matériau d'au moins 50 %, par exemple une capacité d'utilisation de matériau d'environ 60 à 70 %.

7. Cathode tubulaire segmentée selon une quelconque revendication précédente, dans laquelle ladite cathode tubulaire segmentée comprend un aimant interne (34) capable de se déplacer axialement entre au moins un premier segment (22) et un second segment (24).

8. Système de dépôt physique en phase vapeur (PVD) (10) comprenant :
une cathode (20) selon une quelconque revendication précédente, et un aimant (34) suspendu dans un vide partagé à l'intérieur desdits segments de cathode (22, 24) ;
ledit aimant (34) étant raccordé à un arbre (74) de sorte que ledit aimant (34) puisse être actionné axialement entre lesdits segments (22, 24).

9. Système PVD selon la revendication 8, comprenant en outre une chambre à vide (30) ayant une surface intérieure (32), et dans lequel ladite cathode (20) se trouve à l'intérieur de ladite chambre à vide (30).

10. Cathode tubulaire segmentée ou système PVD selon une quelconque revendication précédente, comprenant en outre un tube fin (72) (dans ledit vide) dans lequel ledit tube fin (72) maintient chacun desdits segments (22, 24) en place.
